# EUROPÄISCHE PATENTSCHRIFT

(11) **EP 1 101 124 B1**
(45) Veröffentlichungstag und Bekanntmachung des Hinweises auf die Patenterteilung: **23.02.2005**
(21) Anmeldenummer: 99948652.5
(22) Anmeldetag: 16.07.1999
(51) Int. Cl.: G01R 33/032

(54) **POLARIMETRISCHER SENSOR ZUR OPTISCHEN ERFASSUNG EINER MESSGRÖSSE SOWIE VERWENDUNG DES POLARIMETRISCHEN SENSORS**
POLARIMETRIC SENSOR FOR OPTICAL DETECTION OF A MEASURED VARIABLE AND UTILIZATION OF SAID POLARIMETRIC SENSOR
DETECTEUR POLARIMETRIQUE POUR DETECTION OPTIQUE D'UNE GRANDEUR DE MESURE ET UTILISATION DUDIT DETECTEUR POLARIMETRIQUE

(30) Priorität: 29.07.1998 DE 19834219
(43) Veröffentlichungstag der Anmeldung: 23.05.2001
(73) Patentinhaber: SIEMENS AKTIENGESELLSCHAFT, 80333 München (DE)
(72) Erfinder: MOHR, Stephan, D-07747 Jena (DE); WILLSCH, Michael, D-90762 Fürth (DE); BOSSELMANN, Thomas, D-91080 Marloffstein (DE)
(86) Internationale Anmeldenummer: PCT/DE1999/002226
(87) Internationale Veröffentlichungsnummer: WO 2000/007032

(56) Entgegenhaltungen:
- EP-A- 0 473 429
- US-A- 4 531 092
- US-A- 5 719 497
- GUERRERO H ET AL: "MAGNETIC-FIELD SENSOR USING PLASTIC OPTICAL FIBER AND POLYCRYSTALLINE CDMNTE" SENSORS AND ACTUATORS A,CH,ELSEVIER SEQUOIA S.A., LAUSANNE, Bd. A39, Nr. 1, 1. September 1993 (1993-09-01), Seiten 25-28, XP000413744 ISSN: 0924-4247
- SHINZO MUTO ET AL: "PLASTIC FIBER OPTICAL ISOLATOR AND CURRENT SENSOR" JAPANESE JOURNAL OF APPLIED PHYSICS,JP,PUBLICATION OFFICE JAPANESE JOURNAL OF APPLIED PHYSICS. TOKYO, Bd. 31, Nr. 3B, 15. März 1992 (1992-03-15), Seiten L346-L348, XP000323118 ISSN: 0021-4922
- PATENT ABSTRACTS OF JAPAN vol. 016, no. 012 (P-1297), 13. Januar 1992 (1992-01-13) & JP 03 231177 A (MATSUSHITA ELECTRIC IND CO LTD), 15. Oktober 1991 (1991-10-15)

## Beschreibung

Die Erfindung betrifft einen polarimetrischen Sensor zur optischen Erfassung eines Magnetfelds. Außerdem bezieht sich die Erfindung auf die Verwendung des polarimetrischen Sensors.

Es ist ein optischer Magnetfeldsensor zur Erfassung eines Magnetfelds, das insbesondere durch einen in einem Stromleiter fließenden elektrischen Strom hervorgerufen wird, bekannt. Dabei wird der Faraday-Effekt genutzt. Dieser Magnetfeldsensor wird auch als magnetooptischer Stromwandler bezeichnet. Unter dem Faraday-Effekt versteht man die Drehung der Polarisationsebene von linear polarisiertem Licht, das sich in einem Medium in Anwesenheit eines Magnetfelds ausbreitet. Der Winkel dieser Drehung ist dabei proportional zum Wegintegral des magnetischen Felds entlang des vom Licht zurückgelegten Wegs mit der Verdet-Konstanten als Proportionalitätskonstanten. Die Verdet-Konstante ihrerseits ist abhängig von dem Material, in dem sich das Licht ausbreitet, und von der Wellenlänge des Lichts. Zum Messen des Stroms ist ein Faraday-Element in Form eines optisch transparenten, den Faraday-Effekt zeigenden Materials in der Nähe des Stromleiters angeordnet. In dieses Faraday-Element wird linear polarisiertes Licht eingekoppelt. Das von dem elektrischen Strom erzeugte Magnetfeld bewirkt eine Drehung der Polarisationsebene des sich in dem Faraday-Element ausbreitenden Lichts um einen Polarisationsdrehwinkel, der von einer Auswerteeinheit als Maß für die Stärke des Magnetfelds und damit für die Stärke des elektrischen Stroms ausgewertet wird.

Bekannt ist auch ein optischer Sensor zur Erfassung eines elektrischen Felds (= E-Feldsensor), wobei das elektrische Feld insbesondere durch eine elektrische Spannung hervorgerufen werden kann. Dabei wird z.B. der Pockels-Effekt genutzt. Ein solcher E-Feldsensor wird auch als elektrooptischer Wandler bezeichnet. Unter dem Pockels-Effekt versteht man eine durch das elektrische Feld hervorgerufene Phasenverschiebung zwischen zwei zueinander orthogonalen Polarisationskomponenten eines insbesondere zirkular polarisierten Lichts, das sich in einem Medium in Anwesenheit eines elektrischen Felds ausbreitet. Dadurch wird der zirkulare Polarisationszustand im allgemeinen Fall in einen elliptischen Polarisationszustand überführt. Aus dieser Polarisationsänderung lässt sich eine Messgröße für das zu detektierende elektrische Feld ermitteln.

Aus dem Aufsatz "*Development of Optical Current Transformers and Application to Fault Location Systems for Substations*" *Y. Yamagata et al., IEEE Transactions on Power Delivery, Vol*. *8, No*. *3, July 1993, Seiten 1 bis* 7 ist ein magnetooptischer Stromwandler bekannt, der ein Faraday-Element aus einem als Wismutsiliciumoxid(BSO)-Einkristall ausgebildeten Volumenelement enthält. Die Schreibweise "BSO" stellt hierbei eine Abkürzung für einen Kristall mit der Elementzusammensetzung Bi₁₂SiO₂₀ oder Bi₄Si₃O₁₂ dar. Dieses Faraday-Element befindet sich in einem Luftspalt eines magnetischen Flusskonzentrators, der einen stromführenden elektrischen Leiter umgibt. Durch die Flusskonzentration ergibt sich in dem Luftspalt ein homogenes Magnetfeld, das praktisch ausschließlich durch einen in dem Stromleiter fließenden elektrischen Strom bestimmt wird. Ein in das Faraday-Element eingestrahltes polarisiertes Licht ändert seine Polarisationsebene unter dem Einfluss des Magnetfelds im Luftspalt. Diese Polarisationsmodulation wird in einem unmittelbar an das Faraday-Element angrenzenden Analysator in eine Intensitätsmodulation umgesetzt. Das resultierende Lichtsignal wird per Lichtwellenleiter zu einer Auswerteeinheit geführt, die aus der Intensitätsmodulation den Stromwert berechnet. Je nach Position der Auswerteeinheit kann die durch die Lichtwellenleiter zu überbrückende Strecke bis zu mehrere Kilometer betragen. Gerade bei so großen Distanzen werden bevorzugt Glasfaser-Lichtwellenleiter eingesetzt, da sie sich aufgrund ihrer niedrigen Dämpfung für eine Anwendung mit langer optischer Übertragungsstrecke besonders gut eignen.

Aus der *EP 0 473 429 A2* ist ein Magnetfeldsensor bekannt, der ein Faraday-Element in Form eines Volumenelements beinhaltet. Das Faraday-Element ist zwischen einem lichtleitenden Polarisator und einem lichtleitenden Analysator angeordnet, die beide jeweils als Prismablock mit einer innen liegenden, geneigten Fläche ausgebildet sind. An der geneigten Fläche des Polarisators und derjenigen des Analysators wird auftreffendes Licht jeweils um 90° umgelenkt. Die Zu- und Ableitung von Licht erfolgt hierbei über Lichtwellenleiter. Zur Bündelung eines aus einem Eingangslichtwellenleiter austretenden bzw. eines in einen Ausgangslichtwellenleiter einzuspeisenden Lichts sind jeweils Kollimatoren in Form von sphärischen oder zylinderförmigen Linsen vorgesehen. Diese werden bei dem offenbarten Magnetfeldsensor dafür benötigt, um eine Strahlaufweitung des austretenden Lichts zu vermeiden und um eine ausreichende Lichteinkopplung in den sehr kleinen Kernquerschnitt des Ausgangslichtwellenleiters sicherzustellen. Generell bedingt der Einsatz von Lichtwellenleitern mit kleinen Kerndurchmessern erhöhte Anforderungen an die Justagegenauigkeit bei der Fertigung. Bei Monomode-Lichtwellenleitern liegt der Kerndurchmesser beispielsweise in der Größenordnung weniger µm. Allgemein ist es derzeit üblich, für einen Magnetfeldsensor spezielle Glasfaser-Lichtwellenleiter mit sehr kleinem Kernquerschnitt einzusetzen. Die beim Stand der Technik für den Magnetfeldsensor eingesetzten Komponenten wie Lichtquelle und -empfänger, Lichtwellenleiter, Polarisatoren und Kollimatoren sind meist aufwendige und damit teuere Spezialkomponenten, die insbesondere auf den infraroten Wellenlängenbereich abgestimmt sind.

In *Patent Abstracts of Japan, Vol. 016, No. 012* wird zur *JP 03-231177 A* ein polarimetrischer Sensor beschrieben, der zur optischen Magnetfelderfassung bestimmt ist. Die Sensoreinheit des polarimetrischen Sensors ist in einem Luftspalt eines Flusskonzentrators, der im Luftspalt eine im Wesentlichen einheitliche Feldorientierung des zu detektierenden Magnetfelds bewirkt, angeordnet. Der Eingangs- und der Ausgangslichtwellenleiter werden mittels Nuten, die der Flusskonzentrator auf beiden Seiten des Luftspalts aufweist, an die Sensoreinheit herangeführt. Zur Einkopplung des aus der Sensoreinheit austretenden Lichtsignals ist eine sphärische Kollimationslinse vorgesehen.

Mit der *US 5,475,489* wird ein polarimetrischer Sensor in Form eines Magnetfeldsensors oder eines E-Feldsensors in jeweils reflexiver Anordnung offenbart, bei dem das in ein als Faraday- bzw. Pockels-Element ausgebildetes Sensorelement eingestrahlte Lichtsignal durch mindestens ein Reflexionselement auf einen Ausgangslichtwellenleiter fokussiert wird. Dieses Reflexionselement ist dabei aufwendig in der Herstellung und ist bei der Montage sehr genau in Relation zu dem Ausgangslichtwellenleiter zu positionieren.

Weiterhin ist aus der *DE 39 42 547 A1* ein Magnetfeldsensor auf Basis eines Yttrium-Eisen-Granats (YIG) in ebenfalls reflexiver Anordnung bekannt. Zur Steigerung der Empfindlichkeit ist bei diesem Magnetfeldsensor vorgesehen, dass das Lichtsignal das YIG-Sensorelement zweimal durchläuft. Deshalb ist eine reflexive Anordnung vorgesehen, bei der der Yttrium-Eisen-Granat eine konvexe Stirnfläche aufweist, die das Lichtsignal zum einen reflektiert und zum anderen auf den Ausgangslichtwellenleiter fokussiert. Ein derartiger Yttrium-Eisen-Granat lässt sich jedoch ebenfalls nur mit beträchtlichem Aufwand herstellen. Auch hier ist große Sorgfalt bei der Positionierung des Eingangs- und Ausgangslichtwellenleiters bezüglich ihrer relativen Anordnung zur konvexen Stirnfläche des Yttrium-Eisen-Granats erforderlich.

Mit der *US 4,812,767* wird ein Magnetfeldsensor in reflexiver Anordnung offenbart, der neben dem Polarisator, dem Faraday-Element und dem Analysator zwei unabhängig voneinander aufgebaute Prismen zur Strahlumlenkung beinhaltet. Dieser Aufbau findet sich in einem zylinderförmigen Rohr, so dass der Magnetfeldsensor insgesamt sehr groß und auch teuer in der Herstellung wird.

Aus der *US 4,560,932* ist ein weiterer Magnetfeldsensor bekannt, bei dem das Lichtsignal zur Erhöhung der Empfindlichkeit innerhalb des Faraday-Elements mehrfach reflektiert wird. Diese Mehrfachreflexion geht jedoch mit einer Strahlaufweitung des Lichtsignals einher, so dass nach Durchlaufen des Faraday-Elements nur noch ein sehr geringer Anteil der Intensität des Lichtsignals in den Ausgangslichtwellenleiter eingekoppelt wird. Die Messinformation lässt sich dann nur unter erhöhtem Aufwand aus dem empfangenen Lichtsignal rekonstruieren.

Die *US 5,008,611* sowie die *DE 2 017 863* sind Dokumente des allgemeinen Stands der Technik auf dem Gebiet der magnetooptischen Messtechnik. In beiden Dokumenten wird jeweils ein Magnetfeldsensor beschrieben, der eine mehr oder weniger aufwendige Strahlführungsoptik für das Lichtsignal beinhaltet. So bedient sich der mit der *DE 2 017* 863 offenbarte Magnetfeldsensor einer Speziallinse, deren Vorder- und Rückseite jeweils unterschiedliche Krümmungsradien und außerdem aufgrund einer verschiedenartigen Verspiegelung einen unterschiedlichen Reflexionsgrad aufweisen.

In dem Aufsatz "*Magnetic-field sensor using plastic optical fiber and polycrystalline CdMnTe*" "*von H. Guerrero et al., Sensors and Actuators, A39, 1993, Seiten 25 bis 28* wird ein polarimetrischer Magnetfeldsensor mit einem 0,55 mm oder 0,76 mm dicken Faraday-Element auf Basis von polykristallinem CdMnTe beschrieben. Die eng zusammengefügte Sensoreinheit umfasst einen Polarisator, das Faraday-Element und einen Spiegel. Ein eingespeistes Lichtsignal passiert den Polarisator und das Faraday-Element also zweimal - ein erstes Mal in Vorwärtsrichtung und nach Reflexion am Spiegel ein zweites Mal in Rückwärtsrichtung. Zur unmittelbaren Zu- und Abführung des Lichtsignals zu bzw. von der Sensoreinheit wird ein einziger Plastik-Lichtwellenleiter mit großem Kerndurchmesser (= 2 mm) verwendet. Zwischen diesem Plastik-Lichtwellenleiter und der Sensoreinheit sind keine Mittel zur Fokussierung und/oder Kollimation vorgesehen. An seinem von der Sensoreinheit beabstandeten Ende ist der Lichtwellenleiter mit großem Kerndurchmesser an einen Eingangs- und einen Ausgangslichtwellenleiter mit jeweils kleinerem Kerndurchmesser (= 1 mm) angeschlossen. Zur Bestimmung der Messcharakteristik ist die Sensoreinheit zusammen mit einer kalibrierten Hall-Sonde zwischen die beiden Pole eines Elektromagneten gebracht und in dem dort erzeugten im Wesentlichen einheitlichen Magnetfeld vermessen worden.

Es ist nun Aufgabe der Erfindung, einen polarimetrischen Sensor anzugeben, der sich im Vergleich zum Stand der Technik einfacher und folglich preiswerter herstellen lässt. Insbesondere sollen möglichst einfach herzustellende und damit preiswerte Standardkomponenten eingesetzt und außerdem die bei der Fertigung hinsichtlich der Justagetoleranz gestellten Anforderungen reduziert werden können.

Zur Lösung der Aufgabe wird ein polarimetrischer Sensor entsprechend den Merkmalen des unabhängigen Patentanspruchs 1 angegeben.

Der erfindungsgemäße polarimetrische Sensor zur optischen Erfassung eines Magnetfelds umfasst
a) eine Sensoreinheit, die als eng zusammengefügte Einheit umfassend mindestens einen Polarisator, ein auf das Magnetfeld empfindliches Faraday-Element und einen Analysator ausgebildet ist und die in einem Luftspalt eines Flusskonzentrators, der im Luftspalt eine im Wesentlichen einheitliche Feldorientierung des Magnetfelds bewirkt, angeordnet ist,
b) einen Eingangslichtwellenleiter und
c) einen Ausgangslichtwellenleiter mit einem Kerndurchmesser von mindestens 100 µm, wobei
d) die Sensoreinheit, der Eingangslichtwellenleiter und der Ausgangslichtwellenleiter jeweils ohne Zwischenschaltung gesonderter Mittel zur Fokussierung und/oder Kollimation so angeordnet sind, dass ein erstes Lichtsignal nach Austritt aus dem Eingangslichtwellenleiter in die Sensoreinheit und nach Durchlaufen der Sensoreinheit als ein zweites Lichtsignal in den Ausgangslichtwellenleiter eintritt,
e) der optische Weg des ersten Lichtsignals durch das Faraday-Element nicht länger als der 50fache Kerndurchmesser des Ausgangslichtwellenleiters ist und
f) in dem Luftspalt ein im verwendeten Wellenlängenbereich transparenter Prismablock angeordnet ist, in den die Sensoreinheit eingebettet ist, und der zwei senkrecht zur Feldorientierung verlaufende Bohrungen zur Aufnahme des Eingangslichtwellenleiters bzw. des Ausgangslichtwellenleiters sowie zwei jeweils um 45° gegen die Feldorientierung geneigte Prismaflächen, die jeweils eine 90°-Umlenkung des ersten Lichtsignals bewirken, aufweist.

Die Erfindung beruht dabei auf der Erkenntnis, dass ein polarimetrischer Sensor auch mit einem Ausgangslichtwellenleiter mit relativ großem Kerndurchmesser ausgelegt werden kann. Insbesondere ist der eingesetzte, großkernige Lichtwellenleiter ein Standardprodukt der optischen Nachrichtentechnik und damit sehr preiswert.

Aufgrund des großen Kerndurchmessers lässt sich der polarimetrische Sensor auch mit deutlich niedrigeren Anforderungen an die Justagegenauigkeit aufbauen. Übliche Fertigungstoleranzen in der Größenordnung des Kerndurchmessers des Ausgangslichtwellenleiters (ca. 100 µm) können an dieser Stelle ohne weiteres toleriert werden. Dadurch vereinfacht sich die Fertigung erheblich.

Eine weitere Erkenntnis der Erfindung besteht außerdem darin, dass sich ein polarimetrischer Sensor auch ohne jegliche gesonderte Fokussier- und/oder Kollimationsoptik aufbauen lässt. Sensoreinheit sowie Eingangs- und Ausgangslichtwellenleiter werden dazu so plaziert, dass das erste Lichtsignal nach Austritt aus dem Eingangslichtwellenleiter unmittelbar in die Sensoreinheit und von dort wiederum unmittelbar in den Ausgangslichtwellenleiter eingespeist wird. Unter "unmittelbar" ist in diesem Zusammenhang zu verstehen, dass keine weiteren Mittel zur Fokussierung und/oder Kollimation, zwischengeschaltet sind. Eine Strahlumlenkung sowie kurze optische Wegstrecken zwischen Eingangs-/Ausgangslichtwellenleiter und der Sensoreinheit sind hierbei unter den Begriff "unmittelbar" zu subsumieren.

Die als eng zusammengefügte Einheit aufgebaute Sensoreinheit trägt zusätzlich dazu bei, dass die Strahlaufweitung klein bleibt und der polarimetrische Sensor ohne Fokussier- und/oder Kollimationsoptik auskommt. Diese Einheit wird hierbei beispielsweise durch Aufkleben des Polarisators und des Analysators auf das Sensorelement mittels einer extrem dünnen Klebeschicht oder auch durch Aufsprengen des Polarisators und des Analysators direkt auf das Sensorelement erreicht. Die Dicke der gegebenenfalls vorhandenen Klebeschicht beträgt dann vorzugsweise höchstens einige µm, wodurch störende Einflüsse durch Doppelbrechung unterdrückt werden. Durch die resultierende enge Fügung wird außerdem die optische Wegstrecke zwischen Polarisator, Sensorelement und Analysator minimiert. Dies wirkt sich positiv auf die möglichst gering zu haltende Strahlaufweitung des ersten Lichtsignals aus. Zwischen dem Sensorelement einerseits und dem Polarisator oder dem Analysator andererseits kann ggf. ein weiteres Element z.B. in Form eines λ/4- oder π/2-Phasenschiebers vorhanden sein.

Wenn darüber hinaus der Weg des ersten Lichtsignals durch das Sensorelement maximal dem 50fachen Kerndurchmesser des Ausgangslichtwellenleiters entspricht, so führt dies zu einer günstigen, niedrigen Strahlaufweitung. Dann wird ein großer Anteil des ersten Lichtsignals als zweites Lichtsignal in den Ausgangslichtwellenleiter eingespeist.

Dadurch, dass sich die Sensoreinheit mit dem Faraday-Element in einem Luftspalt eines Flusskonzentrators befindet, wird eine Bündelung und somit quasi eine Verstärkung des zu detektierenden Magnetfelds bewirkt. Die Sensoreinheit ist dann innerhalb des Luftspalt einem gebündelten Magnetfeld mit im Wesentlichen einheitlicher Feldorientierung ausgesetzt. Dadurch wird der Messeffekt gesteigert.

Ein in dem verwendeten Wellenlängenbereich transparenter Prismablock aus Kunststoff befindet sich in dem Luftspalt des Flusskonzentrators. Die Sensoreinheit mit dem Faraday-Element ist in einer Aussparung in diesem Prismablock angeordnet. Außerdem nehmen zwei Bohrungen den Eingangs- und den Ausgangslichtwellenleiter auf. Die Bohrungen verlaufen senkrecht zu der Feldorientierung, so dass das aus dem Eingangslichtwellenleiter austretende erste Lichtsignal zunächst an einer um 45° gegen die Feldorientierung geneigten Prismafläche rechtwinklig umgelenkt wird, um dann die Sensoreinheit parallel zur Feldorientierung zu durchlaufen. Danach erfährt das erste Lichtsignal an einer weiteren um 45° gegen die Feldorientierung geneigten Prismafläche eine zweite 90°-Umlenkung, nach der die Einkopplung in den Ausgangslichtwellenleiter erfolgt. Der beschriebene Prismablock bewirkt somit eine Strahlumkehr des aus dem Eingangslichtwellenleiter ausgekoppelten ersten Lichtsignals. Es handelt sich also um einen reflexiven Aufbau. Der Prismablock ermöglicht eine einfache und kompakte Montage, da sowohl die Aussparung für die Aufnahme der Sensoreinheit als auch die Bohrungen für die Aufnahme der beiden Lichtwellenleiter in einfacher Weise hergestellt werden können. Die Endmontage beschränkt sich somit lediglich auf das Einbringen der Sensoreinheit und der beiden Lichtwellenleiter in den vorgefertigten Prismablock. Alle optischen Komponenten befinden sich dann automatisch in richtiger relativer Position zueinander. Aufgrund des großen Querschnitts des Ausgangslichtwellenleiters können die üblichen Fertigungstoleranzen von etwa 0,1 mm an dieser Stelle ohne weiteres toleriert werden.

Besondere Ausgestaltungen und Weiterbildungen des Magnetfeldsensors nach der Erfindung ergeben sich aus den abhängigen Ansprüchen.

Eine vorteilhafte Ausführungsform zeichnet sich dadurch aus, dass der Weg des ersten Lichtsignals durch das Sensorelement. höchstens dem 10fachen Kerndurchmesser des Ausgangslichtwellenleiters entspricht. Bei einem derartig ausgebildeten polarimetrischen Sensor ergibt sich dann eine besonders niedrige Strahlaufweitung.

Vorteilhaft werden Kunststoff-Lichtwellenleiter für den Eingangs- oder den Ausgangslichtwellenleiter oder auch für beide eingesetzt. Diese Lichtwellenleiter sind sehr preiswert und somit für den vorliegenden Anwendungsfall besonders gut geeignet. Der verwendete Lichtwellenleiter besteht insbesondere aus Polymethylmethacrylat (PMMA = Plexiglas), einem Standardmaterial für Kunststoff-Lichtwellenleiter.

In einer anderen vorteilhaften Ausführungsvariante besitzt der Ausgangslichtwellenleiter einen Kerndurchmesser von mindestens 500 µm. Insbesondere bevorzugt ist ein Kerndurchmesser von mindestens 1 mm. Je größer an dieser Stelle der Kerndurchmesser gewählt wird, um so niedriger sind bei der Justage die Anforderungen an die Genauigkeit für die Positionierung der einzelnen Komponenten. Der Kerndurchmesser des Eingangslichtwellenleiters ist diesbezüglich von weit geringerer Bedeutung. Er kann deshalb auch unter dem des Ausgangslichtwellenleiters liegen.

In bevorzugten Ausführungsformen sind sowohl für den Eingangslichtwellenleiter als auch für den Ausgangslichtwellenleiter Multimode-Lichtwellenleiter vorgesehen. Neben Preisvorteilen bietet diese Lichtwellenleiterart mit ihren großen Kerndurchmessern insbesondere für den Ausgangslichtwellenleiter Vorteile bei der Einkopplung des ersten Lichtsignals. Da dieses Kriterium für den Eingangslichtwellenleiter wie bereits erwähnt nicht ausschlaggebend ist, kann er in einer alternativen Ausführungsform auch als Monomode-Lichtwellenleiter ausgeführt sein. Eine weitere Ausgestaltung sieht vor, dass das der Sensoreinheit zugewandte Faserende des Eingangslichtwellenleiters abgerundet ist. Diese Abrundung wird beispielsweise durch eine Wärmebehandlung des Faserendes hergestellt. Die Abrundung hat dann auf das aus dem Eingangslichtwellenleiter austretende erste Lichtsignal eine leicht kollimierende Wirkung.

Der polarimetrische Sensor ist in einer bevorzugten Variante für den Betrieb im sichtbaren Wellenlängenbereich ausgelegt. Für diese Wellenlängen gibt es eine große Vielfalt an Standardkomponenten für Lichtquellen und -empfänger sowie für Polarisatoren und Lichtwellenleiter. Da dies zunehmend auch für den infraroten Wellenlängenbereich zutrifft, arbeitet der Magnetfeldsensor in einer anderen Variante mit infrarotem Licht.

In einer bevorzugten Ausführungsform enthält die Sensoreinheit ein Faraday-Element, das insbesondere in Form eines Volumenelements ausgestaltet ist. Eine bevorzugte Materialwahl für das Faraday-Element ist ein BSO- oder BGO-Einkristall, ein ferromagnetisches Material oder auch ein Flintglas. Unter BSO und BGO werden hier Wismutsilicium- bzw. Wismutgermaniumoxide verstanden. Mögliche Ausführungen sind Bi₁₂SiO₂₀, Bi₄Si₃O₁₂, Bi₁₂GeO₂₀ oder Bi₄Ge₃O₁₂. Als ferromagnetisches Material kommt hier insbesondere ein Seltenes-Erden-Granat in Frage. Eine geeignete derartige Substanz ist beispielsweise YIG (Yttrium Iron Garnet).

In einer vorteilhaften Ausgestaltung besteht der Prismablock aus einem Material, das einen annähernd gleichen Brechungsindex besitzt wie die beiden Lichtwellenleiter. Diese Maßnahme bewirkt, dass die Aufweitung des ersten Lichtsignals im Prismablock gering ausfällt und somit ein hoher Anteil des ersten Lichtsignals in den Ausgangslichtwellenleiter eingekoppelt wird.

Da jeder elektrische Strom naturgemäß mit einem Magnetfeld verknüpft ist, kann der Magnetfeldsensor vorzugsweise auch zur optischen Detektion eines elektrischen Stroms verwendet werden. Die bezüglich der Erfassung des Magnetfelds getroffenen Aussagen und beschriebenen Vorteile gelten somit analog auch für die Verwendung des Magnetfeldsensors zur Erfassung des elektrischen Stroms.

Bevorzugte Ausführungsbeispiele werden nunmehr anhand der Zeichnung näher erläutert. Zur Verdeutlichung ist die Zeichnung nicht maßstäblich ausgeführt und gewisse Merkmale sind schematisiert dargestellt. Im Einzelnen zeigen:
- Figur 1: einen Magnetfeldsensor zur optischen Erfassung eines durch einen elektrischen Strom hervorgerufenen Magnetfelds und
- Figur 2: eine Anordnung einer Sensoreinheit in einem Luftspalt eines Flusskonzentrators.

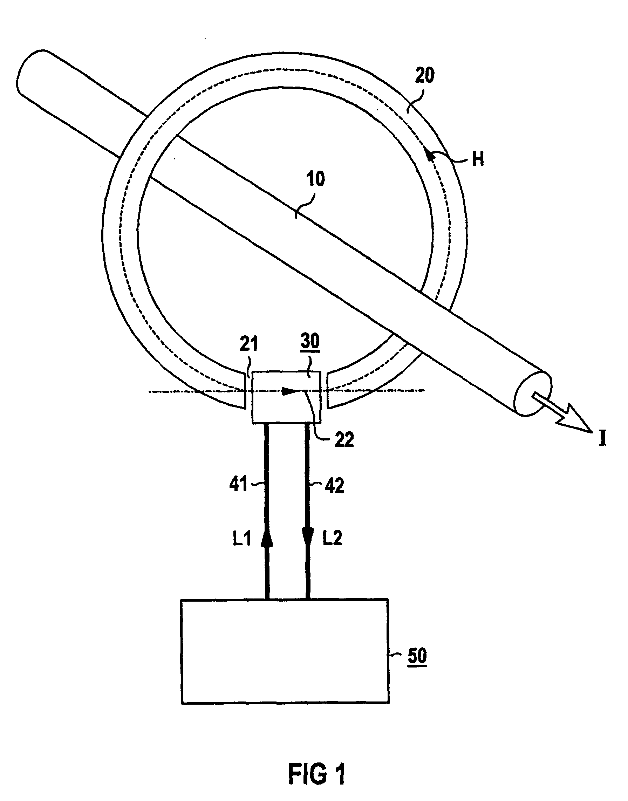

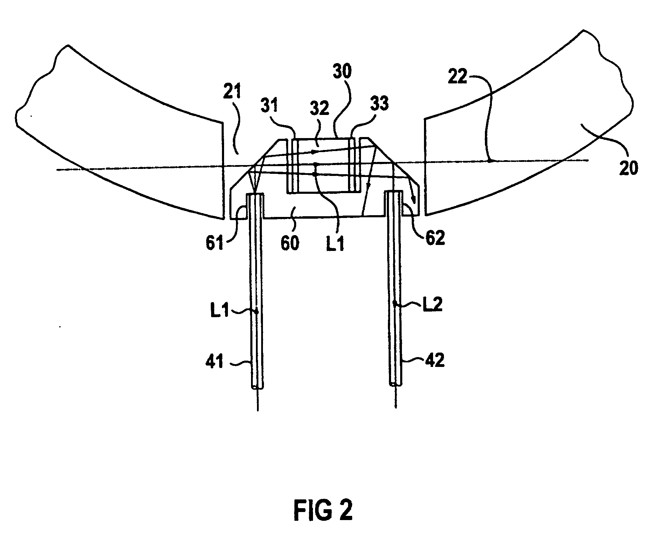

Einander entsprechende Teile sind in den Figuren 1 und 2 mit denselben Bezugszeichen versehen.

In Figur 1 ist als polarimetrischer Sensor ein Magnetfeldsensor zur optischen Erfassung eines Magnetfelds H dargestellt. Das Magnetfeld H wird dabei durch einen elektrischen Strom I, der in einem Stromleiter 10 fließt, hervorgerufen. Der Stromleiter 10 wird von einem Flusskonzentrator 20 umgeben. Der Flusskonzentrator 20 besteht aus einem magnetischen Material, das ansonsten auch für die Kerne konventioneller, induktiver Wandler eingesetzt wird. Im vorliegenden Fall ist der Flusskonzentrator aus einer Nickel-Eisen-Legierung gefertigt. Der Flusskonzentrator dient einer Bündelung des durch den Strom I hervorgerufenen Magnetfelds H. Der Flusskonzentrator 20 ist mit einem Luftspalt 21 versehen, der so ausgebildet ist, dass das Magnetfeld H im Luftspalt praktisch homogen verteilt ist und insbesondere eine einheitliche Feldorientierung 22 aufweist. An den Rändern des Luftspalts 21 kann es zu leichten Abweichungen von dieser einheitlichen Feldorientierung 22 kommen. Sie spielen im vorliegenden Fall jedoch keine Rolle.

In dem Luftspalt 21 des Flusskonzentrators ist eine magnetfeldempfindliche Sensoreinheit 30 angeordnet, die das Magnetfeld H und somit den zugrunde liegenden elektrischen Strom I mit optischen Mitteln detektiert. Dazu sind ein Eingangslichtwellenleiter 41, der der Sensoreinheit 30 ein erstes Lichtsignal L1 zuführt, und ein Ausgangslichtwellenleiter 42, der ein zweites Lichtsignal L2 von der Sensoreinheit 30 abführt, vorgesehen. Innerhalb der Sensoreinheit 30 breitet sich das in die Sensoreinheit 30 eingekoppelte Lichtsignal L1 parallel zur Feldorientierung 22 des Magnetfelds H im Luftspalt 21 aus. Die beiden Lichtwellenleiter 41 und 42 bestehen jeweils aus einem Kunststoff, hier aus PMMA. Außerdem sind die beiden Lichtwellenleiter 41 und 42 als Multimode-Lichtwellenleiter mit einem Kerndurchmesser von 1 mm ausgeführt.

Die Verwendung von Kunststoff-Lichtwellenleitern bietet vor allem dann Vorteile, wenn zum einen die Forderung nach einer preiswerten Strommesseinrichtung besteht und zum anderen die durch die beiden Lichtwellenleiter 41 und 42 zu überbrückenden Distanzen relativ kurz, d.h. nur einige Meter lang, sind. Bei so kurzen Entfernungen spielt die verglichen mit Glasfaser-Lichtwellenleitern höhere Dämpfung keine entscheidende Rolle. Die genannten Bedingungen sind z.B. im Bereich der öffentlichen elektrischen Energieversorgung bei Anwendungen in der Mittelspannungsebene (12 bis 36 kV) gegeben.

Der in Figur 1 dargestellte Magnetfeldsensor erfüllt die Forderung nach einer preiswerten Realisierung aber auch in einer anderen Hinsicht. Der Wellenlängengehalt des ersten und des zweiten Lichtsignals L1 und L2 liegt im sichtbaren Wellenlängenbereich (400 bis 760 nm). Dadurch können auch für andere optische Komponenten Standardbauteile eingesetzt werden. Dies gilt sowohl für die Sensoreinheit 30 als auch für eine optoelektronische Sende-/Empfangseinheit 50. Der erste und der zweite Lichtwellenleiter 41 und 42 verbinden die Sende-/Empfangseinheit 50 und die Sensoreinheit 30 miteinander. Die Sende-/Empfangseinheit 50 umfasst eine Standard-Lichtquelle in Form einer LED (light emitting diode). Die verwendete LED SFH 752 der Firma Siemens emittiert das Lichtsignal L1 mit einer Wellenlänge von 660 nm. Außerdem umfasst die Sende-/Empfangseinheit 50 eine bei dieser Wellenlänge empfindliche Photodiode zur Detektion des von der Sensoreinheit 30 zurückkommenden zweiten Lichtsignals L2. Die Bestimmung der Messgröße erfolgt hierbei anhand einer Auswertung, die an sich bekannt ist und üblicherweise bei einem Magnetfeldsensor oder einem magnetooptischen Stromwandler zum Einsatz kommt. Die Sende-/Empfangseinheit 50 berechnet aus Informationen, die in dem zweiten Lichtsignal L2 codiert enthalten sind, eine Messgröße für das Magnetfeld H oder für den elektrischen Strom I.

In Figur 2 wird in einem Ausführungsbeispiel eine mögliche Realisierung der Sensoreinheit 30 sowie der Lichtzu- und -abführung über den Eingangslichtwellenleiter 41 bzw. den Ausgangslichtwellenleiter 42 detaillierter dargestellt.

Bei dem Beispiel von Figur 2 ist die Sensoreinheit 30 im Luftspalt 21 des Flusskonzentrators 20 angeordnet. Die Sensoreinheit 30 umfasst eine optische Reihenschaltung eines Polarisators 31, eines Faraday-Elements 32 und eines Analysators 33. Das Faraday-Element 32 liegt hier in Form eines Bi₁₂SiO₂₀-Einkristalls vor. Das erste Lichtsignal L1 durchläuft das Faraday-Element parallel zu der Feldorientierung 22. Auf in Lichtrichtung gegenüberliegenden Seitenflächen des Faraday-Elements 32 ist jeweils eine dünne Schicht in Form einer dichroitischen Polarisationsfolie aufgebracht. Die auf der Seitenfläche des Lichteintritts aufgebrachte dünne Schicht dient dabei als Polarisator 31, die auf der Seitenfläche des Lichtaustritts aufgebrachte dünne Schicht als Analysator 33. Die verwendeten dichroitischen Polarisationsfolien sind auf das Faraday-Element 32 aufgeklebt. Sie haben eine Dicke von 0,5 mm. In einem nicht dargestellten alternativen Ausführungsbeispiel sind der Polarisator 31 und der Analysator 33 jeweils als dünne Glasplättchen, die ausgerichtete Silberpartikel enthalten, ausgebildet. Solche Glasplättchen sind beispielsweise unter der Produktbezeichnung Polarcor von der Firma Corning in Dicken zwischen 0,1 mm und 1 mm erhältlich. Um eine möglichst geringe Strahlaufweitung sicherzustellen, liegt die Schichtdicke des Polarisators 31 und des Analysators 33 auch in anderen Ausführungsbeispielen vorzugsweise jeweils bei höchstens 1,5 mm.

Der Polarisator 31 lässt von dem ersten Lichtsignal L1 nur einen Anteil mit vorbestimmter Polarisationsebene passieren. In dem anschließenden Faraday-Element 32 wird diese Polarisationsebene unter dem Einfluss des Magnetfelds H gedreht. Diese Drehung setzt der Analysator 33 in eine Intensitätsmodulation um. Nach Durchlaufen der Sensoreinheit 30 trägt das Lichtsignal somit eine in seiner Intensität codierte Information über das zu messende Magnetfeld H bzw. den ursächlichen elektrischen Strom I. Ein intensitätscodiertes Lichtsignal lässt sich sehr leicht über den verwendeten Multimode-Lichtwellenleiter 42 aus Kunststoff zur Sende-/Empfangseinheit 50 übertragen.

In einer weiteren nicht dargestellten alternativen Ausführungsform kann das aus dem Faraday-Element 32 austretende Lichtsignal in einem nicht dargestellten Analysator in zwei Teillichtsignale mit zueinander senkrechter Polarisation zerlegt werden. Die beiden resultierenden Teillichtsignale tragen jeweils wiederum eine intensitätscodierte Messinformation, die dann entsprechend über zwei Lichtwellenleiter zur Sende-/Empfangseinheit 50 übermittelt werden.

Zur Strahlführung und auch zur Halterung der beiden Lichtwellenleiter 41 und 42 befindet sich in dem Luftspalt 21 ein bei der verwendeten Wellenlänge von 660 nm transparenter Prismablock 60. In ihm sind zwei Bohrungen 61 und 62 vorgesehen, die den Eingangslichtwellenleiter 41 und den Ausgangslichtwellenleiter 42 aufnehmen. Die beiden Bohrungen 61 und 62 verlaufen jeweils senkrecht zu der Feldorientierung 22. Um dennoch einen zur Feldorientierung 22 parallel gerichteten Lichtverlauf in der Sensoreinheit 30, bzw. insbesondere in dem Faraday-Element 32, sicherzustellen, wird das über den Eingangslichtwellenleiter 41 zugeführte erste Lichtsignal L1 an einer um 45° gegen die Feldorientierung 22 geneigten Prismafläche rechtwinklig umgelenkt. Nach Passieren der Sensoreinheit 30, die in einer Aussparung des Prismablocks 60 angeordnet ist, erfolgt eine zweite 90°-Umlenkung an einer weiteren um 45° gegen die Feldorientierung 22 geneigten Prismafläche. Somit wird ein für eine optoelektrische Wandlung in der Sende/Empfangseinheit 50 ausreichend großer Anteil des ersten Lichtsignals L1 als zweites Lichtsignal L2 in den Ausgangslichtwellenleiter 42 eingekoppelt. Insgesamt ergibt sich in dem Prismablock 60 ein U-förmiger Strahlengang des ersten Lichtsignals L1. Es liegt also eine reflexive Anordnung vor.

Die in Figur 2 dargestellte Anordnung kommt ohne jede Fokussier- und/oder Kollimationsoptik aus. Eine Strahlaufweitung des ersten Lichtsignals L1 nach Austritt aus dem Eingangslichtwellenleiter 41 bis zum Wiedereintritt als zweites Lichtsignal L2 in den Ausgangslichtwellenleiter 42 wird mit anderen Maßnahmen möglichst gering gehalten. So sind für die beiden Lichtwellenleiter 41 und 42 sowie für den Prismablock 60 vorteilhaft Materialien mit gleichen oder zumindest mit um höchstens 20% voneinander abweichenden Brechungsindices vorgesehen. Vorliegend wird dies erreicht, indem als Material sowohl für die beiden Lichtwellenleiter 41 und 42 als auch für den Prismablock 60 PMMA gewählt wird.

In einem nicht dargestellten Realisierungsbeispiel ist der Prismablock 60 als Gusskörper ausgeführt. Er wird dabei in seiner endgültigen Form mit der Aussparung für die Sensoreinheit 30, mit den Aufnahmelöchern für die beiden Lichtwellenleiter 41 und 42 und mit den um 45° geneigten Prismaflächen aus einer im verwendeten Wellenlängenbereich transparenten Gussmasse, insbesondere aus Kunststoff, hergestellt.

Der große Kernquerschnitt vor allem des Ausgangslichtwellenleiters 42 bietet sowohl Vorteile beim Wiedereinkoppeln des zweiten Lichtsignals L2, als auch im Hinblick auf die bei der Fertigung einzuhaltende Justagetoleranz. Die Kunststoff-Lichtwellenleiter 41 und 42 mit großem Kernquerschnitt sind in dieser Hinsicht wesentlich unempfindlicher als Glasfaser-Lichtwellenleiter, die ansonsten üblicherweise für einen Magnetfeldsensor eingesetzt werden.

## Patentansprüche

1. Polarimetrischer Sensor zur optischen Erfassung eines Magnetfelds (H), umfassend
a) eine Sensoreinheit (30), die als eng zusammengefügte Einheit umfassend mindestens einen Polarisator (31), ein auf das Magnetfeld (H) empfindliches Faraday-Element (32) und einen Analysator (33) ausgebildet ist und die in einem Luftspalt (21) eines Flusskonzentrators (20), der im Luftspalt (21) eine im Wesentlichen einheitliche Feldorientierung (22) des Magnetfelds (H) bewirkt, angeordnet ist,
b) einen Eingangslichtwellenleiter (41) und
c) einen Ausgangslichtwellenleiter (42) mit einem Kerndurchmesser von mindestens 100 µm, wobei
d) die Sensoreinheit (30), der Eingangslichtwellenleiter (41) und der Ausgangslichtwellenleiter (42) jeweils ohne Zwischenschaltung gesonderter Mittel zur Fokussierung und/oder Kollimation so angeordnet sind, dass ein erstes Lichtsignal (L1) nach Austritt aus dem Eingangslichtwellenleiter (41) in die Sensoreinheit (30) und nach Durchlaufen der Sensoreinheit (30) als ein zweites Lichtsignal (L2) in den Ausgangslichtwellenleiter (42) eintritt,
e) der optische Weg des ersten Lichtsignals (L1) durch das Faraday-Element (32) nicht länger als der 50fache Kerndurchmesser des Ausgangslichtwellenleiters (42) ist und
f) in dem Luftspalt (21) ein im verwendeten Wellenlängenbereich transparenter Prismablock (60) angeordnet ist, in den die Sensoreinheit (30) eingebettet ist, und-der zwei senkrecht zur Feldorientierung (22) verlaufende Bohrungen (61, 62) zur Aufnahme des Eingangslichtwellenleiters (41) bzw. des Ausgangslichtwellenleiters (42) sowie zwei jeweils um 45° gegen die Feldorientierung (22) geneigte Prismaflächen, die jeweils eine 90°-Umlenkung des ersten Lichtsignals (L1) bewirken, aufweist.

2. Polarimetrischer Sensor nach Anspruch 1, **dadurch gekennzeichnet, dass** der optische Weg des ersten Lichtsignals (L1) durch das Faraday-Element (32) nicht länger als der 10fache Kerndurchmesser des Ausgangslichtwellenleiters (42) ist.

3. Polarimetrischer Sensor nach einem der vorhergehenden Ansprüche, **dadurch gekennzeichnet, dass** der Polarisator (31) und der Analysator (33) als dünne Schichten, insbesondere als dichroitische Polarisationsfolien, vorzugsweise mit einer Schichtdicke von höchstens 1,5 mm, längs des optischen Wegs auf einander gegenüberliegenden Seiten des Faraday-Elements (32) angeordnet sind.

4. Polarimetrischer Sensor nach einem der vorhergehenden Ansprüche, **dadurch gekennzeichnet, dass** von dem Eingangslichtwellenleiter (41) und dem Ausgangslichtwellenleiter (42) wenigstens einer aus Kunststoff, insbesondere aus Polymethylmethacrylat, besteht.

5. Polarimetrischer Sensor nach einem der vorhergehenden Ansprüche, **dadurch gekennzeichnet, dass** von dem Eingangslichtwellenleiter (41) und dem Ausgangslichtwellenleiter (42) wenigstens einer, insbesondere der Ausgangslichtwellenleiter (42), als Multimode-Lichtwellenleiter ausgebildet ist.

6. Polarimetrischer Sensor nach einem der vorhergehenden Ansprüche, **dadurch gekennzeichnet, dass** der Ausgangslichtwellenleiter (42) einen Kerndurchmesser von mindestens 500 µm, insbesondere von mindestens 1 mm, aufweist.

7. Polarimetrischer Sensor nach einem der vorhergehenden Ansprüche, **gekennzeichnet durch** eine Auslegung für sichtbares oder infrarotes Licht.

8. Polarimetrischer Sensor nach einem der vorhergehenden Ansprüche, **dadurch gekennzeichnet, dass** der Eingangslichtwellenleiter (41) und der Ausgangslichtwellenleiter (42) jeweils an dem von der Sensoreinheit (30) abgewandten Ende mit einer Sende-/Empfangseinheit (50) verbunden sind, die das erste Lichtsignal (L1) erzeugt und die aus dem zweiten Lichtsignal (L2) ein Messsignal für das Magnetfeld (H) ableitet.

9. Polarimetrischer Sensor nach einem der vorhergehenden Ansprüche, **dadurch gekennzeichnet, dass** der Prismablock (60) aus einem Material besteht, das einen zumindest annähernd gleichen Brechungsindex wie der Eingangslichtwellenleiter (41) und der Ausgangslichtwellenleiter (42) hat.

10. Polarimetrischer Sensor nach einem der Ansprüche 1 bis 8, **dadurch gekennzeichnet, dass** der Prismablock (60), der Eingangslichtwellenleiter (41) und der Ausgangslichtwellenleiter (42) aus dem gleichem Kunststoff, insbesondere aus Polymethylmethacrylat, bestehen.

11. Polarimetrischer Sensor nach einem der vorhergehenden Ansprüche, **dadurch kekennzeichnet,** dass das Faraday-Element (32) als ein Volumenelement aus einkristallinem Wismutsiliciumoxid oder Wismutgermaniumoxid, aus einem ferromagnetischen Material, insbesondere aus einem Seltene-Erden-Granat, vorzugsweise aus einem Yttrium-Eisen-Granat, oder aus einem Flintglas ausgebildet ist.

12. Verwendung des polarimetrischen Sensors nach einem der vorhergehenden Ansprüche zur optischen Erfassung eines in einem elektrischen Leiter (10) fließenden elektrischen Stroms (I), der das von dem Faraday-Element (32) detektierbare Magnetfeld (H) hervorruft.

## Claims

1. Polarimetric sensor for the optical detection of a magnetic field (H), comprising
a) a sensor unit (30), which is embodied as a closely assembled unit comprising at least one polarizer (31), a Faraday element (32) that is sensitive to the magnetic field (H) and an analyser (33), and which is arranged in an air gap (21) of a flux concentrator (20) which, in the air gap (21), effects an essentially uniform field orientation (22) of the magnetic field (H),
b) an input optical waveguide (41) and
c) an output optical waveguide (42) with a core diameter of at least 100 µm,
d) the sensor unit (30), the input optical waveguide (41) and the output optical waveguide (42) being arranged, in each case without the interposition of special means for focussing and/or collimation, such that a first light signal (L1), after emerging from the input optical waveguide (41), enters the sensor unit (30) and, after passing through the sensor unit (30), enters the output optical waveguide (42), as a second optical signal, and
e) the optical path of the first light signal (L1) through the Faraday element (32) is no longer than 50 times the core diameter of the output optical waveguide (42), and
f) in the air gap (21) there is arranged a prism block (60) that is transparent in the wavelength range used, and in which the sensor unit (30) is embedded, and which has two bores (61, 62), running at right angles to the field orientation (22), to accommodate the input optical waveguide (41) and the output optical waveguide (42), and also two prism faces which are each inclined at 45° with respect to the field orientation (22) and each effect a 90° deflection of the first light signal (L1)

2. Polarimetric sensor according to Claim 1, **characterized in that** the optical path of the first light signal (L1) through the Faraday element (32) is no longer than ten times the core diameter of the output optical waveguide (42).

3. Polarimetric sensor according to one of the preceding claims, **characterized in that** the polarizer (31) and the analyser (33) are arranged as thin layers, in particular as dichroic polarization films, preferably having a layer thickness of at most 1.5 mm, along the optical path on mutually opposite sides of the Faraday element (32).

4. Polarimetric sensor according to one of the preceding claims, **characterized in that** at least one of the input optical waveguide (41) and the output optical waveguide (42) consists of a plastic, in particular of polymethyl methacrylate.

5. Polarimetric sensor according to one of the preceding claims, **characterized in that** at least one of the input optical waveguide (41) and the output optical waveguide (42), in particular the output optical waveguide (42), is formed as a multimode optical waveguide.

6. Polarimetric sensor according to one of the preceding claims, **characterized in that** the output optical waveguide (42) has a core diameter of at least 500 µm, in particular of at least 1 mm.

7. Polarimetric sensor according to one of the preceding claims, **characterized by** a design for visible or infrared light.

8. Polarimetric sensor according to one of the preceding claims, **characterized in that** the input optical waveguide (41) and the output optical waveguide (42) are each connected, at the end facing away from the sensor unit (30), to a transmitting/receiving unit (50), which generates the first light signal (L1) and uses the second light signal (L2) to derive a measured signal for the magnetic field (H).

9. Polarimetric sensor according to one of the preceding claims, **characterized in that** the prism block (60) consists of a material which has a refractive index at least approximately equal to the input optical waveguide (41) and the output optical waveguide (42).

10. Polarimetric sensor according to one of Claims 1 to 8, **characterized in that** the prism block (60), the input optical waveguide (41) and the output optical waveguide (42) consist of the same plastic, in particular of polymethyl methacrylate.

11. Polarimetric sensor according to one of the preceding claims, **characterized in that** the Faraday element (32) is formed as a volume element made of monocrystalline bismuth silicon oxide or bismuth germanium oxide, of a ferromagnetic material, in particular of a rare earth garnet, preferably of an yttrium iron garnet, or of a flint glass.

12. Use of the polarimetric sensor according to one of the preceding claims for the optical detection of an electric current (I) which is flowing in an electric conductor (10) and which causes a magnetic field (H) that can be detected by the Faraday element (32).

## Revendications

1. Détecteur polarimétrique de détection optique d'un champ (H) magnétique comprenant
a) une unité (30) de détection qui est constituée sous la forme d'une unité étroitement assemblée comprenant au moins un polariseur (31), un élément (32) de Faraday sensible au champ (H) magnétique et un analyseur (33) et qui est disposé dans un entrefer (21) d'un concentrateur (20) de flux qui provoque dans l'entrefer (21) une orientation (22) sensiblement uniforme du champ (H) magnétique,
b) un guide (41) d'entrée d'ondes lumineuses, et
c) un guide (42) de sortie d'ondes lumineuses ayant un diamètre de coeur d'au moins 100 µm dans lequel
d) l'unité (30) de détection, le guide (41) d'entrée d'ondes lumineuses et le guide (42) de sortie d'ondes lumineuses sont disposés respectivement sans interposition de moyen particulier de focalisation et/ou de collimation de façon à ce qu'un premier signal (L1) lumineux entre, après être sorti du guide (41) de sortie d'ondes lumineuses, dans l'unité (30) de détection et après avoir parcouru l'unité (30) de détection entre en tant que deuxième signal (L2) lumineux dans le guide (42) de sortie d'ondes lumineuse,
e) le trajet optique du premier signal (L1) lumineux dans l'élément (32) de Faraday n'est pas plus long que 50 fois le diamètre de coeur du guide (42) de sortie d'ondes lumineuses, et
f) dans l'entrefer (21) est disposé un bloc (60) de prisme transparent dans le domaine de longueur d'onde utilisé, bloc dans lequel l'unité (30) de détecteur est incorporée et qui a deux trous (61, 62), s'étendant perpendiculairement à l'orientation (22) du champ, pour la réception du guide (41) d'entrée d'ondes lumineuses et du guide (42) de sortie d'ondes lumineuses, ainsi que deux surfaces de prisme inclinées respectivement de 45° par rapport à l'orientation (22) du champ, qui provoquent respectivement une déviation à 90° du premier signal (L1) lumineux.

2. Détecteur polarimétrique suivant la revendication 1, **caractérisé en ce que** le trajet optique du premier signal (L1) lumineux dans l'élément (32) de Faraday n'est pas plus long que 10 fois le diamètre de coeur du conducteur (42) de sortie d'ondes lumineuses.

3. Détecteur polarimétrique suivant l'une des revendications précédentes, **caractérisé en ce que** le polariseur (31) et l'analyseur (33) sont disposés sous forme de couches minces, notamment de feuilles de polarisation dichroïques, de préférence en une épaisseur de couche d'au plus 1,5 mm, le long du trajet optique de côtés mutuellement opposés de l'élément (32) de Faraday.

4. Détecteur polarimétrique suivant l'une des revendications précédentes, **caractérisé en ce que**, parmi le conducteur (41) d'entrée d'ondes lumineuses et le conducteur (42) de sortie d'ondes lumineuses, au moins l'un est en une matière plastique, notamment en poly(méthacrylate de méthyle).

5. Détecteur polarimétrique suivant l'une des revendications précédentes, **caractérisé en ce que**, parmi le conducteur (41) d'entrée d'ondes lumineuses et le conducteur (42) de sortie d'ondes lumineuses, au moins l'un, notamment le conducteur (42) de sortie d'ondes lumineuses, est constitué sous la forme d'un conducteur d'ondes lumineuses multimodes.

6. Détecteur polarimétrique suivant l'une des revendications précédentes, **caractérisé en ce que** le conducteur (42) de sortie d'ondes lumineuses a un diamètre de coeur d'au moins 500 µm, notamment d'au moins 1 mm.

7. Détecteur polarimétrique suivant l'une des revendications précédentes, **caractérisé par** une conception pour de la lumière visible ou infrarouge.

8. Détecteur polarimétrique suivant l'une des revendications précédentes, **caractérisé en ce que** le conducteur (41) d'entrée d'ondes lumineuses et le conducteur (42) de sortie d'ondes lumineuses sont reliés respectivement par l'extrémité éloignée de l'unité (30) de détection à une unité (50) d'émission/réception qui produit le premier signal (L1) lumineux et qui déduit du deuxième signal (L2) lumineux un signal de mesure du champ (H) magnétique.

9. Détecteur polarimétrique suivant l'une des revendications précédentes, **caractérisé en ce que** le bloc (60) formant prisme est en un matériau qui a un indice de réfraction au moins à peu près égal à celui du conducteur (41) d'entrée d'ondes lumineuses et à celui du conducteur (42) de sortie d'ondes lumineuses.

10. Détecteur polarimétrique suivant l'une des revendications 1 à 8, **caractérisé en ce que** le bloc (60) formant prisme, le conducteur (41) d'entrée d'ondes lumineuses et le conducteur (42) de sortie d'ondes lumineuses sont en la même matière plastique, notamment en poly(méthacrylate de méthyle).

11. Détecteur polarimétrique suivant l'une des revendications précédentes, **caractérisé en ce que** l'élément (32) de Faraday est constitué sous la forme d'un élément de volume en oxyde de bismuth-silicium, ou en oxyde de bismuth-germanium, cristallin, en un matériau ferromagnétique, notamment en un grenat de terres rares, de préférence en un grenat d'yttrium et de fer ou en un verre Flint.

12. Utilisation du détecteur polarimétrique suivant l'une des revendications précédentes pour la détection optique d'un courant (I) électrique passant dans un conducteur (10) électrique, courant qui est provoqué par le champ (H) magnétique pouvant être détecté par l'élément (32) de Faraday.
